# EUROPEAN PATENT APPLICATION

(11) **EP 4 576 522 A1**
(43) Date of publication of application: **25.06.2025**
(21) Application number: 24214167.9
(22) Date of filing: 20.11.2024
(51) Int. Cl.: H02K 11/30, H02K 5/08, H02K 5/22, H02K 11/21, H02K 15/142, H05K 3/28

(54) **ELECTRONIC COMPONENT AND METHOD FOR MANUFACTURING SAME**

(30) Priority: 19.12.2023 JP 2023213492
(71) Applicant: AISIN CORPORATION, Kariya, Aichi 448-8650 (JP); Sekisui Chemical Co., Ltd., Osaka-shi, Osaka 530-8565 (JP)
(72) Inventor: KUROZUMI, Takashi, Kariya, 448-8650 (JP); OGATA, Akifumi, Kariya, 448-8650 (JP); KAMIYAMA, Akira, Osaka-shi, 530-8565 (JP)
(74) Representative: Kramer Barske Schmidtchen Patentanwälte PartG mbB

(57) **Abstract**

An electronic component (1) includes: a substrate (10) to which a component is bonded by solder (13); a coating (14) that covers the solder (13); and a covering portion (20) that covers the substrate (10) and the coating (14) and is made of a thermoplastic resin having a melting point higher than a melting point of the solder (13).

## Description

### TECHNICAL FIELD

The present disclosure relates to an electronic component and a method for manufacturing the same.

### BACKGROUND DISCUSSION

Conventionally, electronic components controlled by circuit components on a substrate are known. For example, JP 5704388 B2 discloses a fluid pump controlled by a circuit component on a substrate.

In the conventional technique, a motor housing including a motor or the like and a driver section including a substrate are connected, and the substrate is fixed to a base of the driver section with a screw. Further, when the substrate is exposed without a cover, a cause of failure of the electronic component is likely to occur, and thus, in many cases, the substrate is accommodated in a housing. Fixing with a screw is a simple method, but in general, a plurality of screws are required, and a portion for fixing the screws on the substrate is also required. In addition, a space corresponding to the lengths and widths of the screws is required. Therefore, when the fixing by the screws is adopted, it is difficult to downsize the electronic component. Further, in order to have a structure in which the substrate is accommodated in the housing, it is necessary to design the housing so that a space including the substrate is formed, and it is difficult to downsize the housing including the substrate.

A need thus exists for an electronic component that is miniaturizable and a method for manufacturing the same.

### SUMMARY

In order to realize the above object, an electronic component includes a substrate to which a component is bonded by solder, a coating that covers the solder, and a covering portion that covers the substrate and the coating and is made of a thermoplastic resin having a melting point higher than a melting point of the solder.

That is, in the electronic component, the substrate to which the component is bonded by solder is covered with the thermoplastic resin. Since the thermoplastic resin has a melting point higher than the melting point of the solder, when the covering portion is molded by melting the thermoplastic resin in a state where the solder and the thermoplastic resin are in contact with each other, the solder may be melted. However, since the solder is coated, the possibility of conducting heat to the solder from the molten thermoplastic resin and remelting the solder can be reduced.

With this configuration, the substrate can be covered without being fixed to the housing using screws.

Therefore, even if a structure for screw fixing is not provided on the substrate, the substrate can be protected by the covering portion. Therefore, it is possible to easily downsize the electronic component as compared with a case where a space for screw fixing is provided.

### BRIEF DESCRIPTION OF THE DRAWINGS

The foregoing and additional features and characteristics of this disclosure will become more apparent from the following detailed description considered with the reference to the accompanying drawings, wherein:
Fig. 1A is a plan view illustrating an electronic component, Fig. 1B is a left side view illustrating the electronic component, and Fig. 1C is a front view illustrating the electronic component;
Fig. 2A is a perspective view of the electronic component as viewed obliquely, Fig. 2B is a perspective view of a substrate as viewed obliquely, and Fig. 2C is a perspective view of a substrate to which spacers are attached as viewed obliquely;
Fig. 3A is a plan view illustrating the substrate, Fig. 3B is a left side view illustrating the substrate, and Fig. 3C is a front view illustrating the substrate;
Fig. 4A is a plan view illustrating the substrate to which the spacer is attached, Fig. 4B is a left side view illustrating the substrate to which the spacer is attached, and Fig. 4C is a front view illustrating the substrate to which the spacers are attached;
Fig. 5 is an enlarged cross-sectional view illustrating a bonding portion of a terminal to the substrate;
Fig. 6 is a flowchart illustrating a method for manufacturing the electronic component;
Fig. 7 is a flowchart illustrating a method for manufacturing an electronic component according to another embodiment;
Figs. 8A to 8H are diagrams for explaining the steps in a method for manufacturing the electronic component according to another embodiment; and
Figs. 9A to 9C are diagrams for explaining the steps in a method for manufacturing the electronic component according to another embodiment.

### DETAILED DESCRIPTION

Here, embodiments of the present disclosure will be described in the following order.
(1) Configuration of electronic component:
(2) Method for manufacturing electronic component:
(3) Other embodiments:

### (1) Configuration of electronic component:

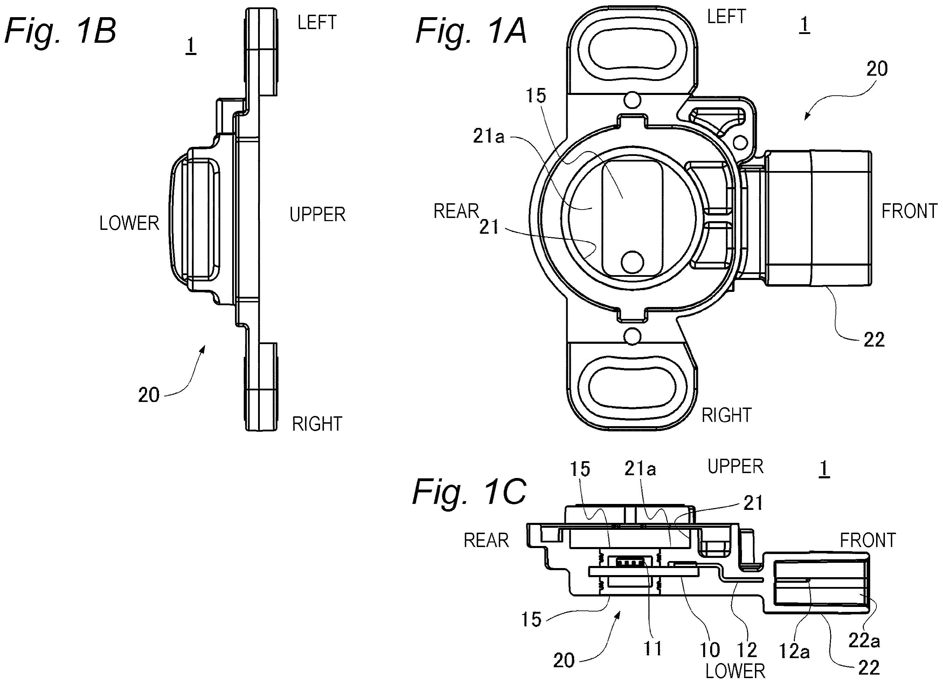

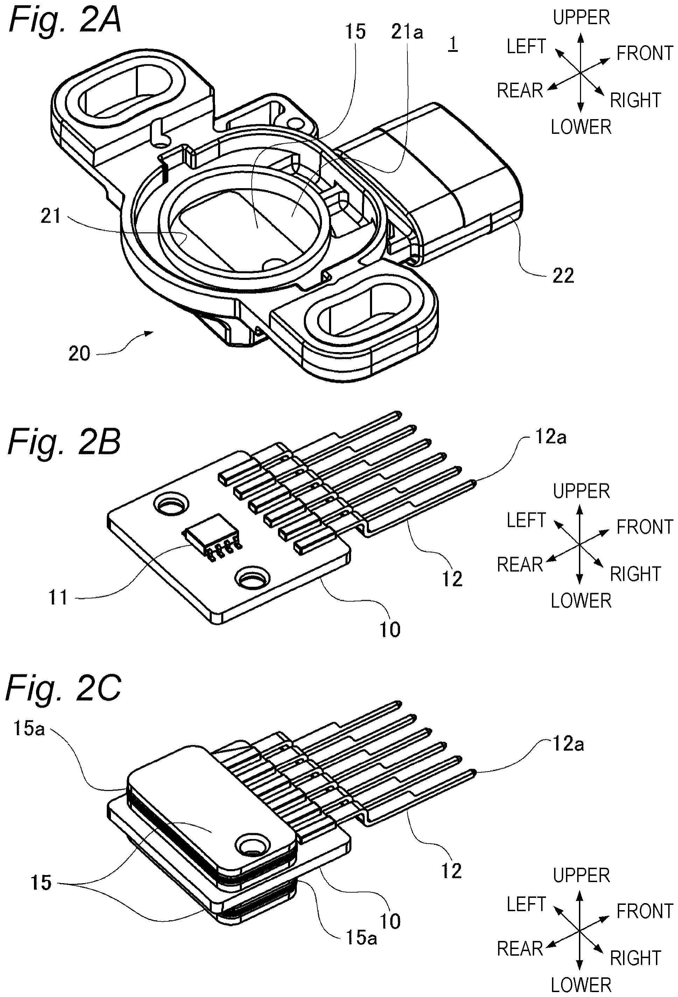

Fig. 1A is a plan view illustrating an electronic component 1, Fig. 1B is a left side view illustrating the electronic component 1, and Fig. 1C is a front view illustrating the electronic component 1. Fig. 2A is a perspective view of the electronic component 1 as viewed obliquely. In the present specification, upper, lower, front, rear, left, and right of the electronic component 1 are defined as illustrated in Fig. 2A for convenience of description. In Fig. 1A, the electronic component 1 is illustrated in a state where the front and rear of the electronic component 1 are disposed on the right and left, and the left and right are disposed on the upper and lower. In Fig. 1B, the electronic component 1 is illustrated in a state where the upper and lower of the electronic component 1 are disposed on the right and left, and the left and right are disposed on the upper and lower. In Fig. 1C, the electronic component 1 is illustrated in a state where the upper and lower of the electronic component 1 are disposed on the upper and lower, and the front and rear are disposed on the right and left. In addition, Fig. 1C illustrates a substrate 10 provided inside the electronic component 1 and a structure around the substrate 10 in a transmissive manner.

The electronic component 1 includes a covering portion 20 constituting most of an outer surface of the electronic component 1. The covering portion 20 covers the substrate 10, and the substrate 10 is not exposed to the outside. In the present embodiment, the electronic component 1 is a rotation sensor using a Hall element as a sensor element.

The shape of the covering portion 20 is not limited to the shape of the covering portion 20 according to the present embodiment, but since the electronic component 1 is the rotation sensor in the present embodiment, the covering portion 20 is formed into a shape for causing the electronic component 1 to function as the rotation sensor. Specifically, a window portion 21 and a connector connection portion 22 are formed in the covering portion 20.

The window portion 21 is a hole of a cylindrical shape formed at the center of the upper surface of the covering portion 20 and extending in an upper-lower direction. An upside of the window portion 21 is opened, and a spacer 15 and a covering portion 20 to be described later exist in a downside of the window portion 21 and are not opened. That is, one surface of the spacer 15 is exposed on the downside of the window portion 21, the covering portion 20 exists around the spacer 15, and the exposed surface of the spacer 15 and a surface 21a of the covering portion 20 form the same surface perpendicular to the upper-lower direction.

In the present embodiment, a magnet is attached to a detection object that is a target for detecting rotation by the rotation sensor. The electronic component 1 is used while being fixed at a position where the magnet of the detection object passes above the upside of the window portion 21. The substrate 10 is disposed on the downside of the spacer 15, and a Hall element 11 is mounted on the substrate 10 (see Fig. 1C). Therefore, when the magnet passes above the upside of the window portion 21, a signal indicating the passage of the magnet is output from the Hall element 11.

A terminal 12 to be described later is attached to the substrate 10. The Hall element 11 receives supply of a drive voltage of the Hall element 11 from an external device via the terminal 12, and outputs a signal output from the Hall element 11 to the external device. A plurality of the terminals 12 are attached to the substrate 10 and extend in a front-rear direction.

The connector connection portion 22 is a hole of a cylindrical shape protruding toward a front side in the covering portion 20. A front side of the connector connection portion 22 is opened, and a rear side thereof is closed by the covering portion 20. However, an end 12a of the front side of the terminal 12 described above is disposed in a space 22a inside the connector connection portion 22. The connector connection portion 22 is a portion to which a connector having a shape slightly smaller than the inner periphery of the inner space 22a is connected. That is, when the connector connected to the external device is inserted into the connector connection portion 22, the Hall element 11 on the substrate and the external device are electrically connected, and the rotation of the detection object can be detected by the external device.

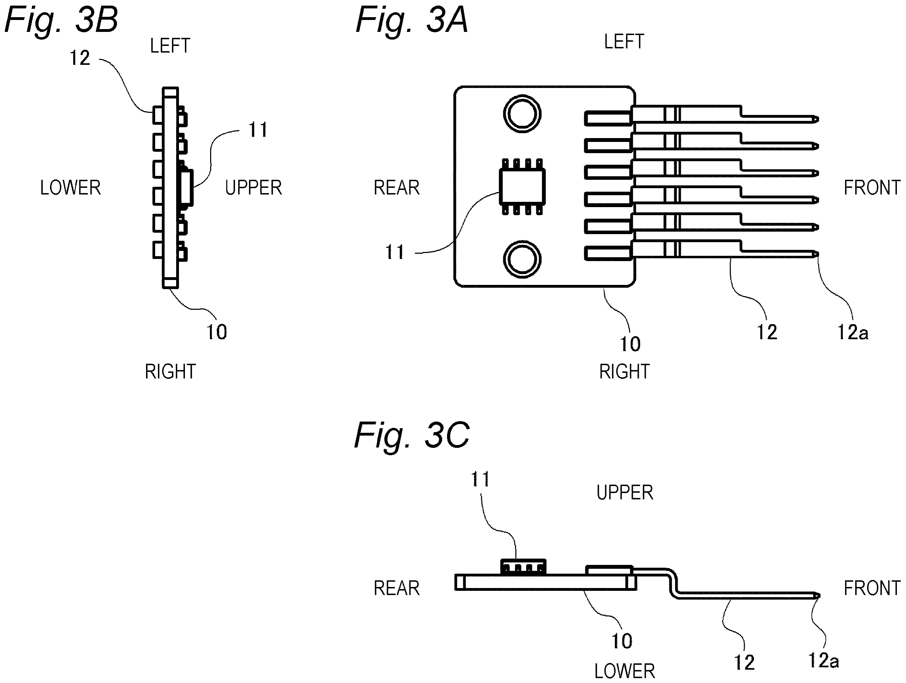

Figs. 3A to 3C are views illustrating the substrate 10 of the electronic component 1. Fig. 3A is a plan view illustrating the substrate 10, Fig. 3B is a left side view illustrating the substrate 10, and Fig. 3C is a front view illustrating the substrate 10. Fig. 2B is a perspective view of the substrate 10 as viewed obliquely. In the present specification, upper, lower, front, rear, left, and right of the electronic component 1 are defined as upper, lower, front, rear, left, and right of the substrate 10 illustrated in Fig. 2A for description. In Fig. 3A, the substrate 10 is illustrated in a state where the front and rear of the substrate 10 are disposed on the right and left, and the left and right are disposed on the upper and lower. In Fig. 3B, the substrate 10 is illustrated in a state where the upper and lower of the substrate 10 are disposed on the right and left, and the left and right are disposed on the upper and lower. In Fig. 3C, the substrate 10 is illustrated in a state where the upper and lower of the substrate 10 are disposed on the upper and lower, and the front and rear are disposed on the right and left.

The substrate 10 is a rectangular parallelepiped, and has a largest surface perpendicular to the upper-lower direction. The substrate 10 is a printed circuit board in which a printed wire, which is not illustrated, is formed on the largest surface. In the substrate 10, a part of the printed wire is formed as a pad, and a portion other than the pad is covered with an insulator. The pad is a portion to which the component is electrically bonded, and in the present embodiment, the component is mounted on the substrate 10 by solder.

In the substrate 10 illustrated in Figs. 3A to 3C, the component includes the Hall element 11 and the terminal 12. The Hall element is a chip including a plurality of terminals, and is soldered to substantially the center of the mounting surface of the substrate 10. In the present embodiment, the six terminals 12 are present in total, and the six terminals 12 are soldered so as to be aligned in the left-right direction along an edge on a side of the front side at a position close to the front side on the substrate 10. In the present embodiment, the terminal 12 has a thin plate shape, is long in the front-rear direction, and is short in the left-right direction. The terminal 12 is mounted on the substrate 10 so as to extend from the rear side toward the front side. Note that the terminal 12 is bent by approximately 90° at two points in a longitudinal direction, and a portion close to an end including the end 12a of the front side of the terminal 12 has a length smaller in the left-right direction than other portions, but the terminal 12 has an elongated shape extending in the front-rear direction as a whole.

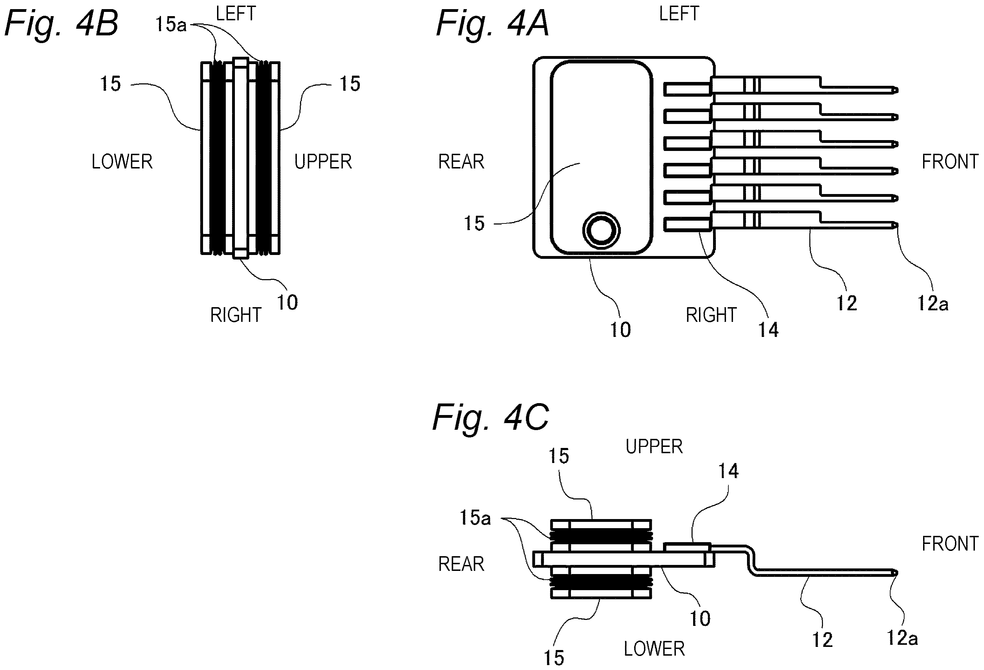

In the present embodiment, the covering portion 20 is made of a thermoplastic resin, and the substrate 10 is also integrally molded when the covering portion 20 is molded. Therefore, the spacer 15 is used so that the position of the substrate 10 is positioned in a mold of the covering portion 20 at the time of molding. Figs. 4A to 4C are views illustrating a state in which the spacer 15 is attached to the substrate 10 illustrated in Figs. 3A to 3C. Fig. 4A is a plan view illustrating the substrate 10 to which the spacer 15 is attached, Fig. 4B is a left side view illustrating the substrate 10 to which the spacer 15 is attached, and Fig. 4C is a front view illustrating the substrate 10 to which the spacer 15 is attached. Fig. 2C is a perspective view of the substrate 10 to which the spacer 15 is attached as viewed obliquely. The upper, lower, front, back, left, and right in Figs. 4A to 4C are defined similarly to those in Figs. 1A to 1C and Figs. 3A to 3C.

The spacer 15 has a shape in which one surface of a hollow hexahedron is opened, and the opened surface is attached to a mounting surface of a component of the substrate 10. In the present embodiment, the spacer 15 is attached to each of the upper and lower mounting surfaces of the substrate 10. The Hall element 11 is accommodated in one of the spacers 15. A buffer portion 15a of a bellows shape is formed on the side surface of the spacer 15, that is, the front, rear, left, and right surfaces in Fig. 4A. With this configuration, for example, it is possible to prevent the substrate 10 from being broken by the force acting when the mold and the spacer 15 are in contact with each other.

When the substrate 10 and the covering portion 20 are integrally molded, the spacer 15 is attached to the substrate 10 in advance. Therefore, the covering portion 20 and the Hall element 11 are not in contact with each other. Further, the surface of the spacer 15 in the upper-lower direction is in contact with a plane formed in a mold used for molding. Therefore, the surface of the spacer 15 in the upper-lower direction can be exposed to the outside of the covering portion 20. Figs. 1A and 2A illustrate a state in which the exposed surface of the spacer 15 and the surface 21a of the covering portion 20 are visually recognized from the upside of the window portion 21.

In the present embodiment, as described above, the covering portion 20 and the Hall element 11 are not in contact with each other.

That is, the solder for mounting the Hall element 11 is isolated from the thermoplastic resin constituting the covering portion 20. However, the covering portion 20 and the terminal 12 are in contact with each other. Such a configuration is realized by injecting a thermoplastic resin into a mold in a state where the substrate 10 illustrated in Figs. 4A to 4C is placed in a mold, which is not illustrated, for molding the covering portion 20 and molding the covering portion 20.

As illustrated in Figs. 1A, 1C, 2A, and the like, the substrate 10 is covered with the covering portion 20, and the terminal 12 is partially exposed inside the connector connection portion 22, but the other portion is covered with the covering portion 20. Therefore, the bonding portion between the terminal 12 and the substrate 10 is covered with the covering portion 20 together with the solder. In the present embodiment, the thermoplastic resin constituting the covering portion 20 is polybutylene terephthalate (PBT), has a melting point of 224 °C, and is molded at 260 °C. On the other hand, solder bonding the terminal 12 to the substrate 10 has a melting point of 217 °C. Therefore, the thermoplastic resin constituting the covering portion 20 has a melting point higher than the melting point of the solder.

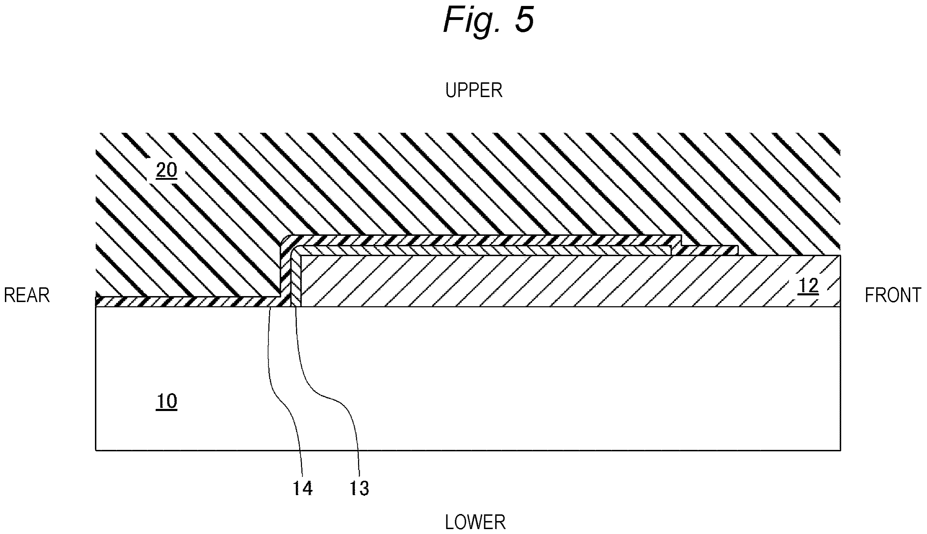

Therefore, when the thermoplastic resin is in contact with the solder bonding the terminal 12 to the substrate 10 at the time of molding the covering portion 20, the solder may be remelted. Thus, in the present embodiment, the solder is coated so that the solder is not in directly contact with the thermoplastic resin. Fig. 5 is an enlarged cross-sectional view illustrating a bonding portion of the terminal 12 to the substrate 10. Fig. 5 illustrates a state in which the terminal 12 on the substrate 10 is cut in a direction perpendicular to the left-right direction. In addition, Fig. 5 illustrates a state after the covering portion 20 is molded, and illustrates a state in which the covering portion 20 is also cut at the same cross section as the terminal 12.

In a portion where the terminal 12 and the substrate 10 are bonded, a solder 13 exists along an outer peripheral surface of the terminal 12. The solder 13 is formed, for example, by bonding the terminal 12 and the substrate 10 by a reflow furnace. In the present embodiment, a coating 14 is formed around the solder 13 over a wider range than the solder 13. That is, the solder 13 is covered with the coating 14 so that the solder 13 formed on the terminal 12 is not in contact with the thermoplastic resin of the covering portion 20 that is integrally molded. Therefore, the thermoplastic resin having a melting point higher than the melting point of the solder 13 and molded at a temperature higher than the melting point of the solder 13 can be prevented from being in contact with the solder 13.

In the present embodiment, the coating 14 contains a coating resin and particles having a thermal conductivity lower than that of the coating resin. That is, the coating 14 contains a plurality of particles, and the thermal conductivity of each particle is smaller than that of the coating resin present around each particle. Therefore, the coating 14 can reduce the possibility of conducting heat to the solder 13 from thermoplastic resin and remelting the solder 13.

In the present embodiment, the coating resin is an ultraviolet curable resin. If the ultraviolet curable resin is used for the coating resin, the coating 14 can be cured by irradiating the coating 14 with ultraviolet rays after the solder 13 is covered with the coating 14.

In addition, the particles contained in the coating 14 only need to have a lower thermal conductivity than the coating resin, so that heat can be conducted from the thermoplastic resin to the solder 13 to reduce the possibility of remelting the solder 13. Therefore, the particle structure, the average particle size, the mixed viscosity of the particles, and the like can be set to various values. For example, an example in which particles having a hollow particle structure, an average particle size of 20 µm, and a mixed viscosity of 2700 mPa·s are contained in the coating 14 can be assumed.

The thickness of the layer of the coating 14 is preferably equal to or more than the average particle size of the particles. According to this configuration, since the thickness is such that one or more particles can exist in the thickness direction of the layer in the coating 14, heat conduction by the particles can be more reliably suppressed as compared with the coating 14 having an average particle size smaller than the average particle size of the particles. Although the thickness of the layer of the coating 14 is not limited, for example, a configuration in which the thickness of the layer is 600 µm when the average particle size of the particles is 40 µm can be adopted. The average particle size of the particles may be selected, for example, from a range of 20 to 50 µm, and the thickness of the layer may be selected, for example, from a range of 100 µm to 1000 µm.

As illustrated in Fig. 3A or the like, in the present embodiment, each of the plurality of terminals 12 is mounted on the substrate 10 by the solder 13. Therefore, there are a plurality of the solders 13 corresponding to the plurality of terminals 12, and the coating 14 covers the respective solders 13 of the plurality of terminals 12. However, in the present embodiment, the solder for mounting the Hall element 11 on the substrate 10 is covered with the spacer 15 and is not in contact with the thermoplastic resin (that is, they are isolated), and thus does not need to be coated with the coating 14. That is, the coating 14 does not need to cover each of the solders isolated from the thermoplastic resin. According to the configuration, the use amount of the material of the coating 14 can be reduced as compared with a configuration in which solder for mounting the Hall element 11 on the substrate 10 is coated.

### (2) Method for manufacturing electronic component:

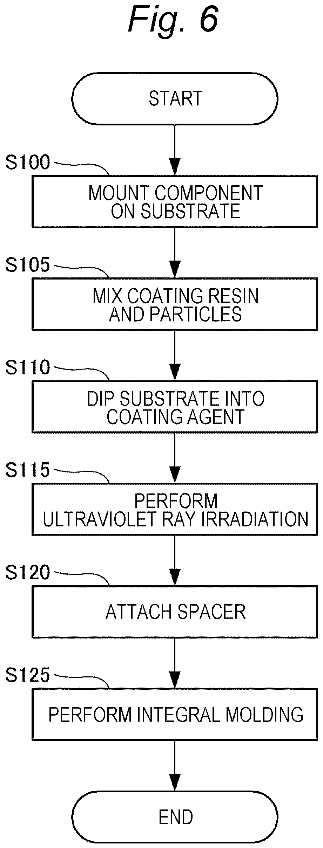

Fig. 6 is a flowchart illustrating a method for manufacturing the electronic component. When an electronic component is manufactured, the component is first mounted on a substrate (step S100). Specifically, the substrate 10 is prepared on which the printed wire for realizing a circuit designed in advance is formed. In addition, components for realizing the circuit designed in advance are mounted on the substrate 10 by solder. In the electronic component 1 illustrated in Figs. 1A, 3A, 4A, and the like, the Hall element 11 and the terminal 12 are soldered to the substrate 10 by reflow or the like. The state after soldering is, for example, the state illustrated in Figs. 3A to 3C.

Next, the coating resin and the particles are mixed (step S105). That is, a coating resin which is liquid at normal temperature is prepared in a container, and a predetermined amount of particles is charged into the container and mixed.

Next, the substrate is dipped into the coating agent (step S110). That is, the substrate is immersed in the coating agent prepared in step S105. At this time, if the coating 14 is not present, immersion is performed so that solder at a position where the covering portion 20 is in contact with the thermoplastic resin is immersed in the coating agent.

Next, the coating agent is irradiated with ultraviolet rays (step S115). That is, after the substrate is taken out from the coating agent, the coating agent is irradiated with ultraviolet rays. In the case of the electronic component 1 illustrated in Figs. 1A, 3A, 4A, and the like, the coating agent or the like covering the solder 13 of the terminal 12 is irradiated with ultraviolet rays. The state after the coating 14 is formed is, for example, the state illustrated in Figs. 4A to 4C.

Next, a spacer is attached (step S120). That is, the spacer is attached to the substrate in order to set the position of the substrate in the covering portion and the position of the substrate in the mold to predetermined positions. In the electronic component 1 illustrated in Figs. 1A, 3A, 4A, and the like, the spacers 15 are attached to both surfaces of the substrate 10. The state after the spacer 15 is formed is, for example, the state illustrated in Figs. 4A to 4C.

Next, integral molding is performed (step S125). That is, the substrate to which the spacer is attached is set in the mold, and the thermoplastic resin is injected into the mold. As a result, the space around the substrate is filled with the thermoplastic resin, and the substrate and the covering portion are integrally molded. In the electronic component 1 illustrated in Figs. 1A, 3A, 4A, and the like, the substrate 10 to which the spacers 15 are attached is set in the mold and integral molding is performed. The state after the covering portion 20 is formed by integral molding is, for example, the state illustrated in Figs. 1A to 1C.

Through the above steps, the electronic component 1 in which the substrate 10 and the coating 14 are covered with the covering portion 20 and a part of the terminal 12 is exposed is manufactured. According to the above configuration, when integral molding is performed, the possibility that the solder 13 on the substrate 10 is remelted by heat from the molten thermoplastic resin can be reduced. With this configuration, the substrate 10 can be covered without being fixed to the housing using screws. Therefore, without the need to provide a structure for screw fixing on the substrate 10, the substrate 10 can be protected. Therefore, the electronic component 1 can be downsized. In addition, since it is not necessary to use screws to fix the substrate 10, the number of components and the number of manufacturing steps can be reduced.

Further,

### (3) Other embodiments:

The above embodiment is an example for carrying out the present disclosure, and various other embodiments can be adopted. For example, the electronic component only needs to include a substrate, a coating, and a covering portion, and the application of the electronic component is not limited. In addition, the covering portion may be formed by integrally molding components other than the substrate together with the substrate.

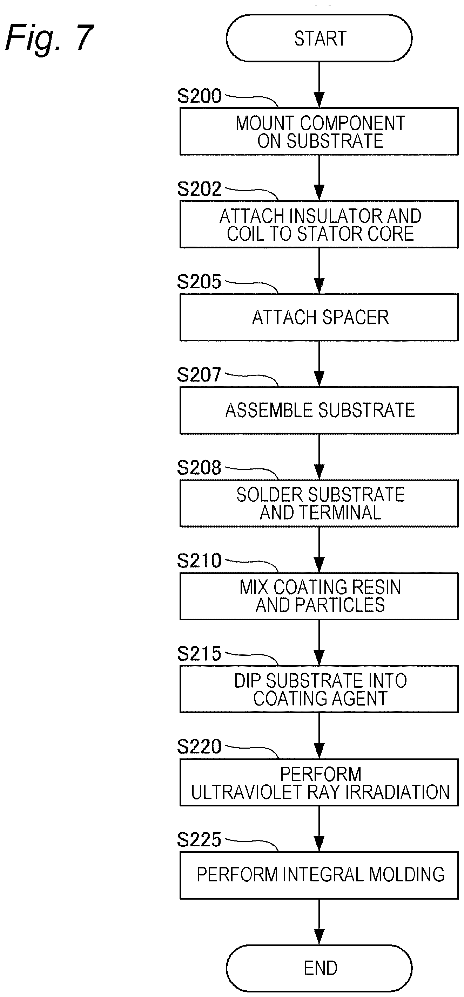

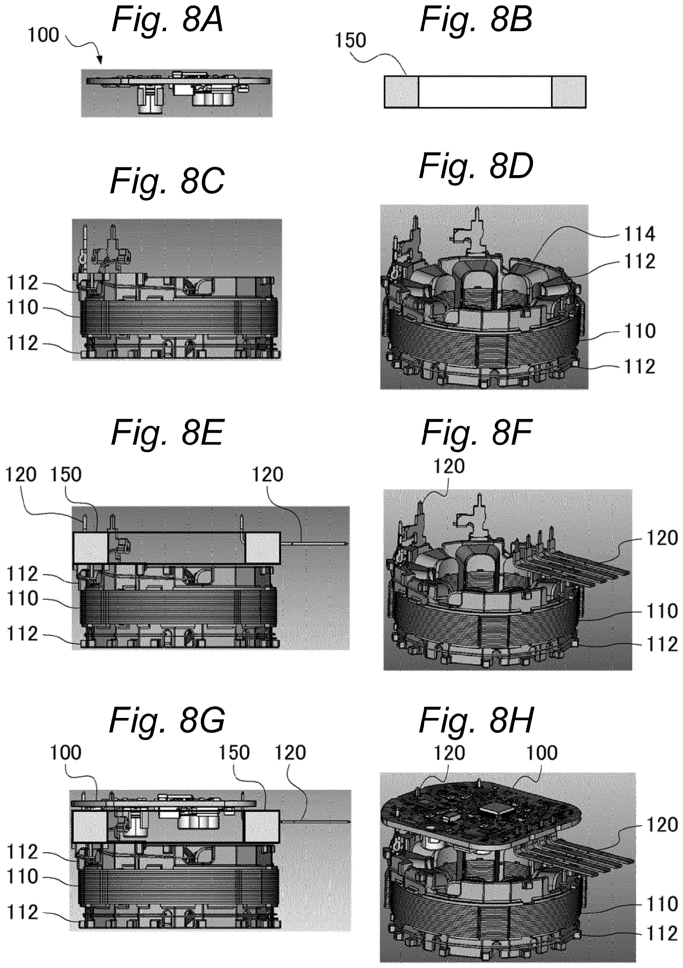

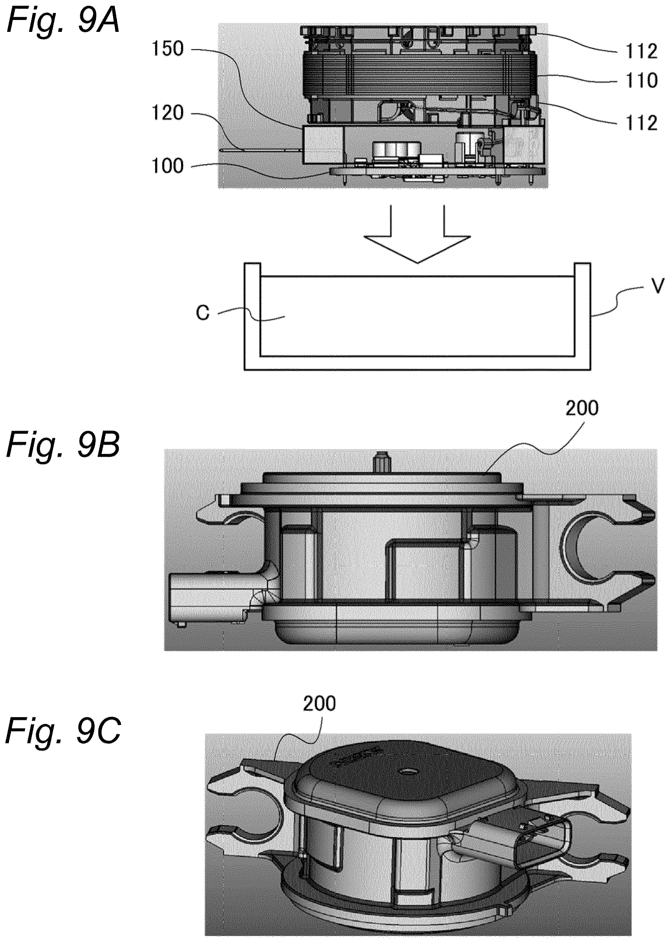

Figs. 7 to 9C are views illustrating an example in which an electric pump including a motor controlled by a substrate is an electronic component according to an embodiment. Fig. 7 is a flowchart illustrating a method for manufacturing the electronic component. Figs. 8A to 8H and Figs. 9A to 9C are diagrams for explaining the steps.

In the present embodiment also, when an electronic component is manufactured, the component is first mounted on a substrate (step S200). Specifically, a substrate 100 on which the printed wire for realizing a circuit with which a motor is controlled is formed is prepared, and circuit components for realizing the circuit are mounted on the substrate 10 by solder. Each of the circuit components is soldered by reflow or the like, for example. Fig. 8A is a view illustrating the substrate 100 after soldering.

Next, an insulator and a coil are attached to a stator core (step S202). In the present embodiment, the substrate 100 and a part of the components of the motor are integrally molded with the covering portion. Therefore, a motor component to be integrally molded is prepared. In the present embodiment, the integrally molded component of the motor includes the stator core, the insulator, and the coil.

In the present embodiment, the motor includes a rotor and the stator core. The rotor is a component that rotates about a rotation axis. In the present embodiment, the rotor is not an object to be integrally molded with the substrate 100. Here, a direction parallel to the rotation axis of the rotor is referred to as an axial direction, a direction perpendicular to the axial direction is referred to as a radial direction, and a rotation direction with respect to the rotation axis is referred to as a circumferential direction. In addition, a direction facing the rotation axis in the radial direction is referred to as a radially inward, and a direction facing a direction opposite to the rotation axis in the radial direction is referred to as a radially outward.

Figs. 8C and 8D are views illustrating the stator core 110 to which the insulator 112 and the coil 114 are attached. Fig. 8C illustrates a state in which the stator core 110 is viewed along the radial direction, and Fig. 8D illustrates a state in which the stator core 110 is viewed from an oblique direction. The stator core 110 is a component fixed to a motor case or the like. Although the configuration of the stator core 110 is not limited, in the present embodiment, the stator core 110 is an annular component existing circumferentially outward from the rotor. A plurality of a stator teeth protruding radially inward is formed radially inward of the annular stator core 110. In the circumferential direction, a space between the plurality of stator teeth is a slot, and forms a space around which the coil is wound.

The insulator 112 is a component that sandwiches the stator teeth from both sides in the axial direction, and is a member for insulating the stator core 110 and the coil 114. The coil 114 is wound around the stator teeth to which the insulator 112 is attached, and is routed radially outward of the insulator 112 to be connected to the substrate 100. Note that the insulator 112 is provided with a terminal or the like for routing wiring extending from the coil 114 to the substrate 100.

In step S202, as illustrated in Figs. 8C and 8D described above, the insulator 112 is attached to the stator core 110, and the coil 114 is wound.

Next, a spacer is attached (step S205). In the present embodiment, the spacer 150 is attached to the stator core 110 in order to set the position of the substrate 100 in the covering portion and the position of the substrate 100 in the mold to predetermined positions and set the position of the terminal bonded to the substrate 100 to predetermined positions. Fig. 8B illustrates an example of the spacer 150. The spacer 150 may have any desired shape as long as the positions of the substrate 100 and the terminals can be set to predetermined positions.

Fig. 8E illustrates an example in which the spacer 150 is attached to the stator core 110. Note that the perspective view illustrated in Fig. 8F illustrates the terminal 120, but the spacer 150 is omitted. As illustrated in Fig. 8F, in a state where the substrate 100 does not exist, since a base or the like for attaching the terminal 120 does not exist in a part of the terminal 120, positioning is performed by attaching the terminal 120 to the spacer 150. Similarly to the terminal 12 illustrated in Figs. 3A to 3C, the terminal 120 illustrated in the upper right part of Fig. 8E is a terminal to which a connector is connected, and a part of the terminal 120 is covered with the covering portion 200 to be described later, and a part of the remaining is not covered with the covering portion 200 and is exposed.

Next, assembly of the substrate 100 is performed (step S207). That is, the spacer 150 has a structure (for example, an engaging portion or the like), which is not illustrated, to which the substrate 100 is assembled, and the substrate 100 is assembled to the spacer 150 using the structure. At this time, the terminal 120 is also configured to be at a predetermined position with respect to the substrate 100. In the present embodiment, the substrate 100 is in a state where one end of the terminal 120 passes through a hole formed in advance in the substrate 100.

Fig. 8G illustrates an example in which the substrate 100 is attached to the spacer 150. As illustrated in Fig. 8G, the substrate 100 is positioned by the spacer 150. Note that the perspective view illustrated in Fig. 8H illustrates the substrate 100, but the spacer 150 is omitted.

Next, the substrate and the terminal are soldered (step S208). That is, in step S207, the end of the terminal 120 protruding from the one surface of the substrate 100 is bonded to the substrate 100 by solder.

Next, the coating resin and the particles are mixed (step S210). That is, a coating resin which is liquid at normal temperature is prepared in a container, and a predetermined amount of particles is charged into the container and mixed.

Next, the substrate is dipped into the coating agent (step S215). That is, the substrate is immersed in the coating agent prepared in step S210. Fig. 9A is a diagram for explaining immersion. In step S210, the solder on the substrate 100 is coated by moving the substrate 100 downward with respect to a container V in which a coating agent C is accumulated. In the present embodiment, immersion is performed such that all the solder used for bonding the components to the substrate 100 is immersed in the coating agent.

Next, the coating agent is irradiated with ultraviolet rays (step S220). That is, after the substrate 100 is taken out from the container V, the coating agent is irradiated with ultraviolet rays.

Next, integral molding is performed (step S225). That is, the stator core 110 to which the spacer 150 and the substrate 100 are attached is set in the mold, and the thermoplastic resin is injected into the mold. As a result, the space around the substrate 100 is filled with the thermoplastic resin, and the substrate 100 and the covering portion 200 are integrally molded. Figs. 9B and 9C are views illustrating the covering portion 200 after being integrally molded, Fig. 9B illustrates a state in which the covering portion 200 is viewed along the radial direction of the stator core 110 in the covering portion 200, and Fig. 9C illustrates a state in which the covering portion 200 is viewed from an oblique direction. Through the above steps, the electronic component is manufactured in which the substrate 100, the coating of the solder for mounting the component on the substrate 100, the stator core 110, the insulator 112, the coil 114, and a part of the terminal 120 are covered by the covering portion 200, and the remaining part of the terminal 120 is exposed.

In the above configuration also, when integral molding is performed, the possibility that the solder on the substrate 100 is remelted by heat from the molten thermoplastic resin can be reduced. With this configuration, the substrate 100 can be covered without being fixed to the housing using screws, and the electronic component can be downsized. In addition, since it is not necessary to use screws to fix the substrate 10, the number of components and the number of manufacturing steps can be reduced.

The substrate only needs to be a substrate to which components are bonded by solder. That is, a circuit for exchanging various signals with other electronic components bonded to the substrate is formed on the substrate. The circuit formed on the substrate is not limited, and may be a circuit for exchanging information with another electronic component, a circuit for controlling another electronic component, or a circuit controlled by another electronic component. An aspect of the component is not limited, and various sizes, shapes, and types of components may be mounted on the substrate. The component only needs to be bonded to the substrate by solder, and may be various components. For example, the component may be a circuit component such as an active element or a passive element, an integrated circuit, or a terminal joined to another electronic component.

The coating only needs to cover the solder. That is, the coating is a layer that protects the solder, and it is sufficient that the coating is interposed between the solder and the thermoplastic resin to prevent the solder and the thermoplastic resin from being in contact with each other. In addition, it is sufficient that the coating is interposed to reduce the possibility of conducting heat from the molten thermoplastic resin to the solder and remelting the solder.

Note that the coating only needs to be able to reduce the possibility of conducting heat to the solder from thermoplastic resin and remelting the solder. Therefore, to this extent, the material and thickness of the coating are not limited, and can be realized in various states. Furthermore, since the coating is a layer for preventing contact between the thermoplastic resin and the solder, when a component isolated from the thermoplastic resin is present on the substrate, the solder on the component does not need to be coated.

The covering portion only needs to be a portion that covers the substrate and the coating and is made of a thermoplastic resin having a melting point higher than the melting point of the solder. That is, it is sufficient that the thermoplastic resin covers the substrate, and for example, the thermoplastic resin can be manufactured by integrally molding the substrate together with the thermoplastic resin.

In addition, the covering portion may cover the coating on the component mounted on the substrate together with the substrate by covering the substrate. The covering portion only needs to cover all or a part of the substrate and the coating on the component so as not to be exposed to the outside. A component on the substrate, the component being not coated (for example, the terminal in the embodiment described above), may be exposed to the outside of the covering portion. In addition, even in the component on the substrate, a portion where no solder exists may be exposed to the outside of the covering portion.

The thermoplastic resin may be any resin as long as it melts and becomes liquid when the temperature becomes higher than or equal to the melting point, and becomes rubber-like or glassy when the temperature becomes lower than the melting point. In addition, since the melting point is higher than the melting point of the solder, when the thermoplastic resin and the solder are in direct contact with each other during molding, the solder may be remelted. Although the melting point is not limited, for example, an example is assumed in which the melting point of the thermoplastic resin is about 260 °C and the melting point of the solder is 220 °C or lower. Examples of such a thermoplastic resin include PPS, PPA, PBT, and PA. Examples of such solder include Sn-Cu-Ag based solder.

The coating only needs to be able to make the thermal conduction from the thermoplastic resin to the solder smaller than that in the absence of the coating. The composition of the coating having such characteristics is not limited, but it is preferable to contain a coating resin in order to facilitate coating with solder. The material of the coating resin is not limited, and the coating resin may be made of various resins, for example, a thermoplastic resin or the like, in addition to the UV curable resin described above.

The coating only needs to be able to make the thermal conduction from the thermoplastic resin to the solder smaller than that in the absence of the coating, and the material and composition therefor may be in various aspects. For example, the configuration is not limited to the configuration as in the embodiment described above in which the coating resin contains particles having a thermal conductivity lower than that of the coating resin, and the coating resin may be formed of a resin having a thermal conductivity lower than that of the thermoplastic resin.

The particles having a thermal conductivity lower than that of the coating resin may be realized by various particles as long as the particles can suppress heat conduction from the thermoplastic resin to the solder as compared with a state in which only the coating resin is present. Examples thereof include hollow particles.

It is explicitly stated that all features disclosed in the description and/or the claims are intended to be disclosed separately and independently from each other for the purpose of original disclosure as well as for the purpose of restricting the claimed invention independent of the composition of the features in the embodiments and/or the claims. It is explicitly stated that all value ranges or indications of groups of entities disclose every possible intermediate value or intermediate entity for the purpose of original disclosure as well as for the purpose of restricting the claimed invention, in particular as limits of value ranges.

## Claims

1. An electronic component (1) comprising:
a substrate (10) to which a component is bonded by solder (13);
a coating (14) that covers the solder (13); and
a covering portion (20) that covers the substrate (10) and the coating (14) and is made of a thermoplastic resin having a melting point higher than a melting point of the solder (13).

2. The electronic component (1) according to Claim 1, wherein
the coating (14) contains a coating resin and particles having a thermal conductivity lower than that of the coating resin.

3. The electronic component (1) according to Claim 1 or 2, wherein
a plurality of the solders (13) are present on the substrate (10), and
the coating (14) covers all the solders (13) except the solder (13) isolated from the thermoplastic resin.

4. The electronic component (1) according to any one of Claims 1 to 3, wherein
the component includes a terminal electrically connected to an external device and a sensor element, and
the thermoplastic resin covers the substrate (10) that exposes a portion of the terminal and includes the sensor element, and the coating (14).

5. The electronic component (1) according to any one of Claims 1 to 3, wherein
the component includes a terminal electrically connected to an external device and a circuit component with which a motor is controlled, and
the thermoplastic resin covers the substrate (10) that exposes a portion of the terminal and includes the circuit component, the coating (14), and a stator core (110) of the motor.
